# EUROPÄISCHE PATENTSCHRIFT

(11) **EP 1 240 735 B1**
(45) Veröffentlichungstag und Bekanntmachung des Hinweises auf die Patenterteilung: **12.11.2003**
(21) Anmeldenummer: 00991782.4
(22) Anmeldetag: 22.12.2000
(51) Int. Cl.: H04B 10/155

(54) **KOMMUNIKATIONSMODUL MIT PARALLELEN SENDEDIODEN**
COMMUNICATION MODULE COMPRISING PARALLEL TRANSMITTING DIODES
MODULE DE COMMUNICATION A DIODES EMETTRICES PARALLELES

(30) Priorität: 23.12.1999 DE 19963605
(43) Veröffentlichungstag der Anmeldung: 18.09.2002
(73) Patentinhaber: Infineon Technologies AG, 81669 München (DE)
(72) Erfinder: ARETZ, Kurt, 46419 Isselburg (DE); STANGE, Herwig, 14167 Berlin (DE); BLANK, Juergen, 14193 Berlin (DE)
(74) Vertreter: Müller, Wolfram Hubertus, Dipl.-Phys.
(86) Internationale Anmeldenummer: DE0004669
(87) Internationale Veröffentlichungsnummer: WO01048953

(56) Entgegenhaltungen:
- EP-A- 0 525 684
- DE-A- 19 623 883
- PATENT ABSTRACTS OF JAPAN vol. 017, no. 570 (E-1448), 15. Oktober 1993 (1993-10-15) & JP 05 167170 A (FUJITSU LTD), 2. Juli 1993 (1993-07-02)

## Beschreibung

Die Erfindung betrifft ein Kommunikationsmodul mit mehreren parallelen Sendedioden nach dem Oberbegriff des Anspruchs 1. Sie ermöglicht insbesondere die Stabilisierung des Modulationsgrades der optischen Ausgangsleistung mehrerer auf einem gemeinsamen Substrat angeordneter Sendedioden.

Derartige Kommunikationsmodule finden in der Lichtwellenleiter-Technik Verwendung. Hierbei werden mehrere Sendedioden benachbart zueinander, vorzugsweise auf einem gemeinsamen Substrat angeordnet, so daß die mehreren Sendedioden im wesentlichen gleiche elektrooptische Eigenschaften aufweisen. Eine solche Anordnung wird auch als ein Sendediodenarray bezeichnet. Die mehreren Sendedioden können beispielsweise als Laserdioden ausgebildet sein.

Um die mehreren Sendedioden zur Datenübertragung nutzen zu können, ist das von den Sendedioden ausgesendete Licht entsprechend den zu übertragenden digitalen Daten moduliert. Das ausgesendete Licht kann zur Übertragung in Lichtwellenleiter eingekoppelt werden. Mit Hilfe der mehreren Sendedioden werden mehrere Übertragungskanäle gespeist.

Aus JP-3-36778 ist eine Vorrichtung mit mehreren Sendedioden bekannt, bei der eine Monitoreinrichtung benutzt wird, um die Sendeleistung der Sendedioden zu überwachen und zu regeln. Die Monitoreinrichtung umfaßt eine als Diode ausgebildete Sendeeinrichtung, eine Empfangseinrichtung und eine Steuereinrichtung. Das von der Sendeeinrichtung emittierte Licht wird mit Hilfe der Empfangseinrichtung erfaßt, die beispielsweise als Photodiode ausgebildet ist. Ein mittels der Empfangseinrichtung empfangenes Signal wird an die Steuereinrichtung übermittelt und hier ausgewertet. Die Steuereinrichtung erzeugt auf der Basis des ausgewerteten Signals Steuersignale zur Regelung der Sendeleistung der mehreren Sendedioden.

Die EP-A-0 525 684 beschreibt ein gattungsgemäßes Kommunikationsmodul mit mehreren, parallelen Sendedioden und einer Monitor-Sendediode. Dabei ist vorgesehen, die Größe des Modulationshubs zur Kompensation der Temperaturabhängigkeit des Extinktionsverhältnisses temperaturabhängig zu wählen. Hieraus resultiert für die in der Mitte (bei höheren Temperaturen) angeordneten Sendedioden ein höherer Modulationshub als für die am Rand liegende Monitor-Sendediode.

Aus der DE 196 23 8B3 A ist ein gattungsgemäßes Kommunikationsmodul mit mehreren, parallelen Sendedioden für die Datenübertragung und einer Monitor-Sendediode bekannt, der eine Monitordiode zugeordnet ist.

Aufgabe der vorliegenden Erfindung ist es, ein Kommunikationsmodul der eingangs beschriebenen Art zu schaffen, das eine verbesserte Überwachung und Regelung der optischen Ausgangsleistung der Sendedioden ermöglicht.

Diese Aufgabe wird bei einem Kommunikationsmodul nach dem Oberbegriff des Anspruchs 1 erfindungsgemäß dadurch gelöst, daß eine separate Sendediode für einen Monitor-Regelkreis (Monitor-Sendediode) verwendet wird, wobei der Modulationshub des Modulationsstroms für die Monitor-Sendediode geringer ist als der Modulationshub des Modulationstroms für die Sendedioden, die ein Datensignal übertragen. Dabei ist die Monitor-Sendediode den Sendedioden für die Datenübertragung benachbart und weist identische oder weitgehend ähnliche opto-elekronische Eigenschaften auf. Über die Regelung und Einstellung des Modulationshubs der Monitor-Sendediode für den Monitorkreis ist somit der Modulationshub für die Sendedioden einstellbar.

Ein wesentlicher Vorteil, welcher mit der Erfindung gegenüber dem Stand der Technik erreicht ist, besteht darin, daß mit Hilfe des geringeren Modulationshubs des Modulationsstroms für die Monitor-Sendediode ein Störeinfluß des Monitorsignals auf die Sendedioden und hierdurch auf deren optischen Ausgang durch Nebensprechen oder Übersprechen des Monitorsignals verhindert ist. Das Monitorsignal bildet insbesondere dann eine Störquelle, wenn die Sendedioden und die Monitor-Sendediode in räumlicher Nähe, beispielsweise auf einem gemeinsamen Substrat angeordnet sind.

Ein weiterer Vorteil besteht darin, daß die Sendedioden bei der erfindungsgemäßen Lösung auch übermoduliert, d.h. mit einem Betriebsstrom unterhalb des Schwellstroms betrieben werden können, während die Modulation des Stroms für den Monitor-Regelkreis bzw. die Monitor-Sendediode, die ja einen geringeren Modulationshub aufweist, im linearen Bereich erfolgen kann.

Durch die Verwendung separater Sendedioden für den Monitorkreis, die mit den Kommunikationskanälen der Sendedioden optisch nicht gekoppelt sind, kann im Monitorkreis ein Pilottonsignal unabhängig von den Datensignalen für die Sendedioden generiert und ausgewertet werden.

Unter einem Modulationshub im Sinne der Erfindung ist der durch den HIGH-Level und den LOW-Level eines digitalen Datensignals definierte Hub zu verstehen. Es handelt sich dabei um einen Amplitudenhub. Da ein Laser üblicherweise mit einer Stromquelle angesteuert wird (die Ausgangsleistung ist dem Strom proportional), erfolgt die Modulation eines Stroms und liegt ein Modulationshub am Modulationsstrom vor.

Eine bevorzugte Ausgestaltung der Erfindung sieht vor, daß der Modulationshub des Modulationsstroms für die Monitor-Sendediode so niedrig ist, daß die Monitor-Sendediode stets im linearen Bereich der Betriebskennlinie betrieben werden kann, wodurch der Einfluß von Nichtlinearitäten und sich hieraus ergebenden Fehlern bei der Überwachung und Regelung des optischen Ausgangs der Sendedioden vermieden wird.

Eine vorteilhafte Ausgestaltung der Erfindung sieht vor, daß sich der der Modulationshub des Modulationsstroms für die Monitor-Sendediode und der Modulationshub des Modulationstroms für die Sendedioden um einen konstanten Faktor unterscheiden. Dadurch kann der Modulationshub für die Sendedioden mit Hilfe einer einfachen Verstärkerschaltung aus dem Modulationshub für den Monitorkanal erzeugt werden. Den Sendedioden wird dann ein entsprechend vergrößerter Modulationsstrom zugeführt. Die Überwachung und Regelung des gewünschten Modulationshubs erfolgt also über den Monitorkreis. Der für den Monitorkreis bzw. die Monitor-Sendediode eingestellte Modulationshub wird dann nach Multiplikation mit einem konstanten Faktor den Sendedioden, die die Datensignale übertragen, zugeführt.

Mit Vorteil wird die Monitor-Sendediode mit einer gegenüber den Sendedioden niedrigeren Pilottonfrequenz beschickt. Das entsprechende Pilotsignal ist aufgrund der Verwendung einer eigenen Sendediode für den Monitorkreis völlig unabhängig von den zu übertragenden Datensignalen. Über die Monitoreinrichtung wird der Modulationshub des Pilotsignals erfaßt und mittels der Steuereinrichtung stabil geregelt. Der Modulationshub für die Sendedioden ergibt sich dann aus der Multiplikation des Modulationshubs für die Sendedioden mit einem konstanten Faktor.

Eine vorteilhafte Weiterbildung der Erfindung sieht vor daß die Steuereinrichtung zum Regeln einer mittleren Ausgangsleistung (bzw. des Vorstroms) der Sendedioden und der mindestens einen Monitor-Sendediode einen weiteren Regelkreis umfaßt, wobei mittels des weiteren Regelkreises das von der Empfangseinrichtung empfangene Signal ausgewertet und wenigstens ein zweites Steuersignal an die Treibereinrichtung zur Einstellung des Vorstroms der Sendedioden und der Monitor-Sendediode erzeugt wird. Damit besteht eine weitere Regelungsmöglichkeit der optischen Ausgangsleistung der Sendedioden auf der Basis des Monitorsignals.

Bei einer Weiterbildung der Erfindung ist vorgesehen, daß
- die Monitoreinrichtung eine weitere Monitor-Sendediode und eine weitere Empfangseinrichtung umfaßt,
- ein weiteres mittels der weiteren Monitor-Sendediode erzeugtes, moduliertes, optisches Signal mit Hilfe der weiteren Empfangseinrichtung in ein weiteres Monitorsignal umgewandelt wird, und
- die Empfangseinrichtung und die weitere Empfangseinrichtung mit einer Sicherheitseinrichtung verbunden sind, die die Sendedioden abschaltet, wenn das empfangene Monitorsignal und/oder das weitere empfangene Monitorsignal ein Schwellwertsignal übersteigen.

Hierdurch ist zum Überwachen der Sendeleistung des optischen Ausgangs der Sendedioden eine Sicherheitseinrichtung mit redundantem Aufbau geschaffen. Es sind zwei Monitorkanäle ausgebildet, die jeweils eine Sende- und eine Empfangseinrichtung umfassen und unabhängig voneinander der Sicherheitsüberwachung des optischen Ausgangs der Sendedioden dienen. Das Überschreiten des vorgegebenen, einstellbaren Schwellwertsignals, d.h. einer bestimmten mittleren optischen Ausgangsleistung in einem der Monitorkanäle führt zum Abschalten der Sendedioden. Auch bei Ausfall eines Monitorkanals, beispielsweise wegen einer Funktionsstörung, ist eine Überwachung des optischen Ausgangs der Sendedioden bezüglich des Überschreitens des Schwellwertsignals gewährleistet und ein verbesserter Schutz gegen eine Übersteuerung der Sendedioden geschaffen.

Sind die Sendedioden als Laserdioden ausgebildet, so kann eine Übersteuerung zum Aussenden von Lichtwellen führen, deren Intensität Beschädigungen anderer Bauteile oder des Menschen verursachen. Des weiteren kann eine Übersteuerung zur Zerstörung der Sendedioden selbst führen.

Vorteilhaft kann vorgesehen sein, daß
- die Sicherheitseinrichtung eine Vergleichseinrichtung und eine weitere Vergleichseinrichtung umfaßt,
- das empfangene Monitorsignal an einem Eingang der Vergleichseinrichtung und das weitere empfangene Monitorsignal an einem Eingang der weiteren Vergleichseinrichtung anliegen,
- an einem anderen Eingang der Vergleichseinrichtung und einem anderen Eingang der weiteren Vergleichseinrichtung das Schwellwertsignal anliegt, und
- ein Ausgang der Vergleichseinrichtung und ein Ausgang der weiteren Vergleichseinrichtung mit einem Eingang bzw. einem weiteren Eingang einer ODER-Einrichtung verbunden sind.

Hierdurch ist ein redundanter Aufbau zur Sicherheitsüberwachung des optischen Ausgangs der mehreren Sendedioden mit Hilfe einfacher Schaltungsmittel kostengünstig realisiert.

Die Erfindung wird im folgenden anhand eines Ausführungsbeispiels unter Bezugnahme auf eine Zeichnung näher erläutert. Hierbei zeigen:
- Figur 1: eine schematische Darstellung eines Kommunikationsmoduls und einer zugehörigen Beschaltung; und
- Figur 2: eine grafische Darstellung mit Stromkennlinien.

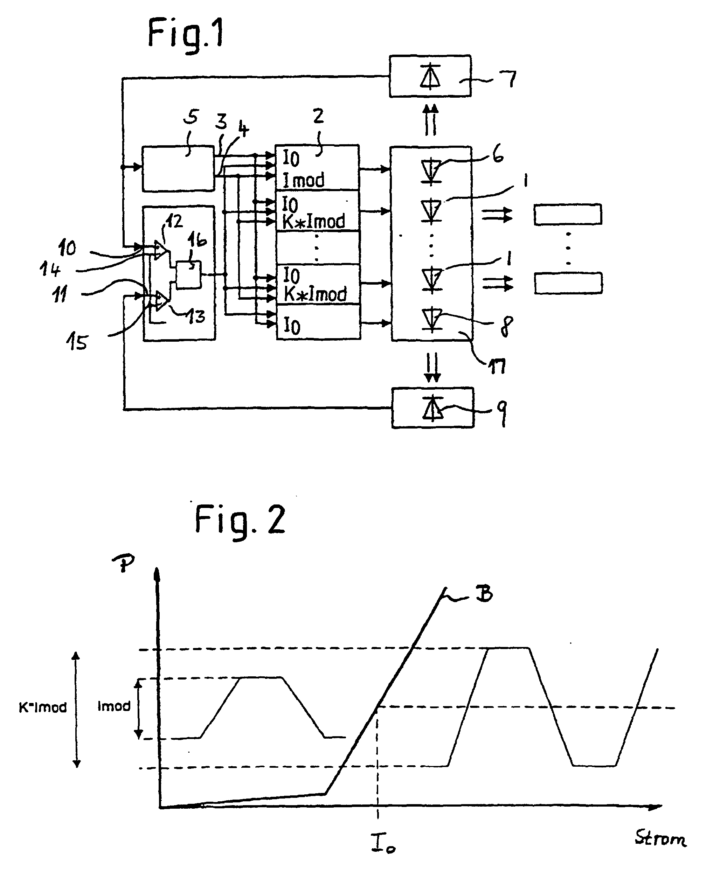

Gemäß Figur 1 umfaßt ein Kommunikationsmodul für die Lichtwellenleiter-Technik mehrere Sendedioden 1, die jeweils mit einer Treiberschaltung 2 verbunden sind. Mit Hilfe der Treiberschaltung 2 werden die zum Betrieb der Sendedioden 1 notwendigen Gleich- und Wechselstromsignale erzeugt. Bei diesen handelt es sich insbesondere um den Vorstrom für die Sendedioden 1, dem ein entsprechend den zu übertragenden Daten modulierter Modulationsstrom überlagert ist. Die jeweiligen Treiberschaltungen 2 sind parallel mit zwei Ausgängen 3,4 einer Steuereinrichtung 5 verbunden.

Das Kommunikationsmodul umfaßt weiterhin zwei Monitor- bzw. Pilottonkanäle, die eine Monitor-Sendediode 6 und eine Empfangsdiode 7 bzw. eine weitere Monitor-Sendediode 8 und eine weitere Empfangsdiode 9 aufweisen. Die Sendedioden 1 und die Monitor-Sendedioden 6, 8 sind auf einem gemeinsamen Substrat 17 angeordnet. Sie sind einander benachbart und weisen identische oder weitgehend ähnliche elektrooptische Eigenschaften auf. Aufgrund der Uniformität der Sendedioden 1 und Monitor-Sendedioden 6, 8 kann über die Regelung der optischen Ausgangsleistung der Monitor-Sendedioden 6, 8 mittels der Monitor- bzw. Pilottonkanäle auch die optische Ausgangsleistung der Sendedioden 1 geregelt werden.

Es handelt sich bei den Sendedioden 1 vorzugsweise um Laserdioden, die vertikal zur Substratoberfläche abstrahlen.

Ein von der Empfangsdiode 7 empfangenes optisches Signal, welches von der Monitor-Sendediode 6 ausgesendet wird, wird in ein Monitorsignal umgewandelt und an die Steuereinrichtung 5 übertragen. Der von der Empfangsdiode 7 generierte Strom (Monitorsignal) repräsentiert dabei die Ausgangsleistung der Monitor-Sendediode 7. Die Steuereinrichtung 5 weist zum Auswerten des empfangenen Monitorsignals einen Regelkreis und einen weiteren Regelkreis (nicht dargestellt) auf. Der Regelkreis dient der Einstellung des Modulationshubs der Monitor-Sendediode 6 und damit der Sendedioden 1. Hierzu wird der Modulationshub des Modulationsstroms Imod der Monitor-Sendediode 1 geregelt. Der weitere Regelkreis dient (durch Regelung des Vorstroms Iₒ) der Einstellung der mittleren optischen Ausgangsleitung der Monitor-Sendediode 6 und damit der Sendedioden 1.

Mit Hilfe des Regelkreises wird ein erstes Steuersignal erzeugt, das über einen der zwei Ausgänge 3 an die jeweiligen Treiberschaltungen 2 übermittelt wird. Mit Hilfe des ersten Steuersignals wird in den jeweiligen Treiberschaltungen 2 ein Modulationshub für den Modulationsstrom der Sendedioden 1 gebildet (Wechselstromansteuerung), wobei der Modulationshub für den Modulationsstrom der Sendedioden 1 geringer ist als der Modulationshub für den Modulationsstrom der Monitor-Sendediode 6 des Monitorkanals.

Mit Hilfe des weiteren Regelkreises wird das empfangene Monitorsignal so ausgewertet, daß ein zweites Steuersignal erzeugt und über einen anderen der zwei Ausgänge 4 an die jeweilige Treiberschaltung 2 übermittelt werden kann. Das zweite Steuersignal wird in der jeweiligen Treiberschaltung 2 verarbeitet, um eine mittlere optische Ausgangsleistung der Sendedioden 1 einzustellen (Gleichstromansteuerung Iₒ ).

Das empfangene Monitorsignal wird somit zur Steuerung des Modulationshubs der Sendedioden 1 und zur Steuerung der mittleren Ausgangsleistung der Sendedioden 1 verwendet.

Das Monitorsignal weist eine gegenüber den Datensignalen der Sendedioden 1 niedrigere Frequenz auf. Es besteht beispielsweise aus einem 101010... Pattern. In dem Regelkreis wird beispielsweise von dem von der Empfangsdiode erfaßten Monitorsignal der Gleichstromanteil abgezogen, der Ist-Wert mit einem Soll-Wert des Modulationshubs verglichen und entsprechend der Abweichung ein Pilotsignal mit geändertem Modulationshub erzeugt.

Gemäß Figur 1 sind die Empfangsdiode 7 und die weitere Empfangsdiode 9 mit Eingängen 10, 11 von Vergleichseinrichtungen 12, 13 verbunden. Ein anderer Eingang 14, 15 der Vergleichseinrichtungen 12, 13 ist jeweils mit einer Vergleichsquelle (nicht dargestellt) verbunden, die ein Schwellwertsignal erzeugt und auf die anderen Eingänge 14, 15 gibt.

Überschreiten die mit Hilfe der Empfangsdiode 7 bzw. der weiteren Empfangsdiode 9 empfangenen Monitorsignale das Schwellwertsignal, so sendet wenigstens eine der Vergleichseinrichtungen 12, 13 ein Signal an eine logische ODER-Einrichtung 16, welche dieses Signal derart verarbeitet, daß ein Abschaltsignal an die jeweilige Treiberschaltung 2 gesendet wird, so daß der weitere Betrieb der mehreren Sendedioden 1, der Sendediode 6 und/oder der weiteren Sendediode 8 unterbrochen wird.

Mit Hilfe der Sendediode 6, der weiteren Sendediode 8, der Empfangsdiode 7 und der weiteren Empfangsdiode 9 ist ein redundanter Aufbau geschaffen, der gewährleistet, daß auch bei Ausfall eines der Monitorkanäle eine Überwachung des optischen Ausgangs der mehreren Sendedioden 1 ermöglicht ist. Ein solcher redundanter Aufbau ist selbstverständlich auch bei bekannten Kommunikationsmodulen einsetzbar, bei denen der Sendemodulationshub des optischen Ausgangs der mehreren Sendedioden 1 nicht, wie oben beschreiben, auf der Basis des empfangenen Monitorsignals gesteuert wird. Unabhängig von dieser beschriebenen Art der Regelung des Sendemodulationshubs auf der Basis der Auswertung des Monitorsignals ergeben sich die Vorteile des redundanten Aufbaus auch im Zusammenhang mit bekannten Kommunikationsmodulen, die den neuartigen redundanten Aufbau bezüglich der Monitorkanäle nicht aufweisen. Es handelt sich dann um ein Kommunikationsmodul, das dadurch gekennzeichnet ist, daß zwei voneinander unabhängige Monitorkanäle gebildet sind, die jeweils eine Sendeeinrichtung und eine Empfangseinrichtung umfassen, wobei ein Ausfall einer der zwei Monitorkanäle zum Abschalten von mehreren Sendedioden des Kommunikationsmoduls führt.

In Figur 2 sind der Verlauf eines Modulationsstroms Imod für die Sendediode 6, eines um den Faktor k verstärkten Modulationsstroms k x Imod für die Sendedioden 1 und eine Betriebskennlinie B der Sendedioden 1 dargestellt. Beim Betrieb der Sendedioden 1 werden diese mit Hilfe eines Gleichstroms (Vorstroms) I₀ auf einen Punkt der Betriebskennlinie B eingestellt. Auf der Basis dieser Einstellung wird dann der optische Ausgang der mehreren Sendedioden mit einem Modulationsstrom 1 moduliert.

Wie in Figur 2 gezeigt ist, ist der Modulationshub des verstärkten Modulationsstroms k x Imod größer als der Modulationshub des Stroms Imod. Der Modulationshub des Modulationsstroms der Sendedioden 1 geht hierbei durch Multiplikation mit dem konstanten Faktor k aus dem Modulationshub des Modulationsstroms Imod der Monitor-Sendediode 6 hervor. Dieses hat den Vorteil, daß die Sendedioden 1 auch übermoduliert werden können, d.h. mit einem Betriebsstrom unterhalb eines Diodenschwellstroms der Sendedioden 1 betreibbar sind, wobei gleichzeitig garantiert ist, daß die Monitor-Sendediode 6 in einem linearen Bereich betrieben wird.

Die Regelung des Modulationshubs der für die Datenübertragung verwendeten Sendedioden 1 erfolgt, indem die Monitor-Sendediode 6 mit einem Monitorsignal (bevorzugt niedriger Frequenz) beschickt wird. Die Ausgangsleistung der Monitor-Sendediode wird durch die Empfangsdiode 7 erfaßt und der Steuereinrichtung 5 zugeführt. Mittels der Regelkreises wird die Amplitude bzw. der Modulationshub des Monitorstroms Imod für die Monitor-Sendediode 6 und damit der Modulationshub der optischen Ausgangsleistung der Monitor-Sendediode 6 stabil auf einen gewünschten Wert eingestellt. Aus dem geregelten Modulationshub für die Monitor-Sendediode 6 wird der Modulationsstrom für die Sendedioden 1 abgeleitet, wobei der Modulationshub des Modulationsstroms für die Sendedioden 1 durch Multiplikation des Modulationshubs des Modulationsstroms für die Monitor-Sendediode 6 mit einem bestimmten Faktor k größer 1 gebildet wird.

Die Regelung des Vorstroms Iₒ bzw. der mittleren optischen Ausgangsleistung der Dioden erfolgt ebenfalls über den Monitorkanal 6, 7 mittels des weiteren Regelkreises. Dabei wird der Ist-Wert der mittleren optischen Ausgangsleistung in der Steuervorrichtung 5 mit einem Sollwert verglichen und der Vorstrom für die Monitor-Sendediode 6 entsprechend eingestellt. Die Monitor-Sendedioden 6, 8 und die Sendedioden 1 werden dabei mit demselben Vorstrom betrieben, so daß über eine Regelung des Vorstroms der Monitor-Sendedioden 6, 8 auch der Vorstrom der Sendedioden geregelt wird. Es wird darauf hingewiesen, daß gemäß Figur 1 die weitere Monitor-Sendediode 8 nur der zusätzlichen Überwachung des Vorstroms für die Sicherheitseinrichtung 12, 13, 16 dient. Es ist jedoch ebenso möglich, auch dieses Monitorsignal mit Imod zu beaufschlagen und ebenfalls der Steuereinrichtung 5 oder einer weiteren Steuereinrichtung zuzuführen.

### Bezugszeichenliste

- 1: Sendedioden
- 2: Treiberschaltung
- 3: Ausgang der Steuereinrichtung 5
- 4: anderer Ausgang der Steuereinrichtung 5
- 5: Steuereinrichtung
- 6: Monitor-Sendediode
- 7: Empfangsdiode
- 8: weitere Monitor-Sendediode
- 9: weitere Empfangsdiode
- 10,11: Eingang der Vergleichseinrichtung 12 bzw. 13
- 12,13: Vergleichseinrichtung
- 14,15: anderer Eingang der Vergleichseinrichtung 12 bzw. 13
- 16: ODER-Einrichtung
- 17: Substrat

## Patentansprüche

1. Kommunikationsmodul mit
- mehreren, parallelen Sendedioden (1) und
- mindestens einer Monitor-Sendediode (6, 8), die den Sendedioden benachbart angeordnet ist und identische oder weitgehend ähnliche opto-electronische Eigenschaften wie die Sendedioden aufweist,
- mindestens einer Treibereinrichtung (2) zur Erzeugung eines Vorstroms und eines Modulationsstroms für die Sendedioden (1) und die Monitor-Sendediode (6, 8) und mit
- mindestens einer Monitoreinrichtung, die die Monitor-Sendediode (6, 8), eine Empfangseinrichtung (7) und eine Steuereinrichtung (5) umfaßt,
- wobei ein von der Monitor-Sendediode (6, 8) erzeugtes, moduliertes optisches Signal von der Empfangseinrichtung (7) erfaßt, umgewandelt und als Monitorsignal an die Steuereinrichtung (5) übermittelte wird, die in Abhängigkeit von dem übermittelten Signal ein erstes Steuersignal an die Treibereinrichtung (2) zur Einstellung des Modulationsstrom für die Sendedioden (1) und die Monitor-Sendediode (6, 8) erzeugt,
**dadurch gekennzeichnet,**
**daß** der Modulationshub (Imod) des Modulationsstroms für die Monitor-Sendediode (6, 8) geringer ist als der Modulationshub (k*Imod) des Modulationstroms für die Sendedioden (1).

2. Kommunikationsmodul nach Anspruch 1, **dadurch gekennzeichnet, daß** der Modulationshub des Modulationsstroms für die Monitor-Sendediode (6, 8) so niedrig ist, daß die Monitor-Sendediode (6, 8) stets im linearen Bereich einer Betriebskennlinie (B) der Monitor-Sendediode (6, 8) betrieben werden kann.

3. Kommunikationsmodul nach Anspruch 1 oder 2, **dadurch gekennzeichnet, daß** der Modulationshub (Imod) des Modulationsstroms für die Monitor-Sendediode (6, 8) und der Modulationshub (k*Imod) des Modulationstroms für die Sendedioden (1) sich um einen konstanten Faktor unterscheiden.

4. Kommunikationsmodul nach einem der vorhergehenden Ansprüche, **dadurch gekennzeichnet, daß** die Steuereinrichtung (5) zum Regeln des Vorstroms der Sendedioden (1) und der mindestens einen Monitor-Sendediode (6, 8) einen weiteren Regelkreis umfaßt, wobei mittels des weiteren Regelkreises das von der Empfangseinrichtung (7, 9) empfangene Signal ausgewertet und wenigstens ein zweites Steuersignal an die Treibereinrichtung (2) zur Einstellung des Vorstroms der Sendedioden (1) und der Monitor-Sendediode (6, 8) erzeugt wird.

5. Kommunikationsmodul nach einem der vorhergehenden Ansprüche, **dadurch gekennzeichnet, daß** die Monitor-Sendediode (6, 8) mit einer gegenüber den Sendedioden (1) niedrigeren Pilottonfrequenz beschickt wird.

6. Kommunikationsmodul nach einem der vorhergehenden Ansprüche, **dadurch gekennzeichnet, daß**
- die Monitoreinrichtung eine weitere Monitor-Sendediode (8) und eine weitere Empfangseinrichtung (9) umfaßt,
- ein weiteres mittels der weiteren Monitor-Sendediode (8) erzeugtes, moduliertes, optisches Signal mit Hilfe der weiteren Empfangseinrichtung (9) in ein weiteres Monitorsignal umgewandelt wird, und
- die Empfangseinrichtung (7) und die weitere Empfangseinrichtung (9) mit einer Sicherheitseinrichtung verbunden sind, die die Sendedioden (1) abschaltet, wenn das empfangene Monitorsignal und/oder das weitere empfangene Monitorsignal ein Schwellwertsignal übersteigen.

7. Kommunikationsmodul nach Anspruch 6, **dadurch gekennzeichnet, daß**
- die Sicherheitseinrichtung eine Vergleichseinrichtung (12) und eine weitere Vergleichseinrichtung (13) umfaßt,
- das empfangene Monitorsignal an einem Eingang (10) der Vergleichseinrichtung (12) und das weitere empfangene Monitorsignal an einem Eingang (11) der weiteren Vergleichseinrichtung (13) anliegen,
- an einem anderen Eingang (14) der Vergleichseinrichtung (12) und einem anderen Eingang (15) der weiteren Vergleichseinrichtung (13) das Schwellwertsignal anliegt, und
- ein Ausgang der Vergleichseinrichtung (12) und ein Ausgang der weiteren Vergleichseinrichtung (13) mit einem Eingang bzw. einem weiteren Eingang einer ODER-Einrichtung (16) verbunden sind.

## Claims

1. Communications module having
- a plurality of parallel transmitting diodes (1) and
- at least one monitor transmitting diode (6, 8), which is arranged adjacent to the transmitting diodes and has identical or largely similar opto-electronic properties to those of the transmitting diodes,
- at least one driver device (2) for generating a biasing current and a modulation current for the transmitting diodes (1) and the monitor transmitting diode (6, 8), and having
- at least one monitor device which comprises the monitor transmitting diode (6, 8), a receiver device (7) and a control device (5),
- a modulated optical signal which is generated by the monitor transmitting diode (6, 8) being registered by the receiver device (7), converted and transmitted as a monitor signal to the control device (5) which, as a function of the transmitted signal, generates a first control signal to the driver device (2) for setting the modulation current for the transmitting diodes (1) and the monitor transmitting diode (6, 8), **characterized in that** the modulation shift (Imod) of the modulation current for the monitor transmitting diode (6, 8) is smaller than the modulation shift (k*Imod) of the modulation current for the transmitting diodes (1).

2. Communications module according to Claim 1, **characterized in that** the modulation shift of the modulation current for the monitor transmitting diode (6, 8) is so low that the monitor transmitting diode (6, 8) can always be operated in the linear range of an operating characteristic curve (B) of the monitor transmitting diode (6, 8).

3. Communications module according to Claim 1 or 2, **characterized in that** the modulation shift (Imod) of the modulation current for the monitor transmitting diode (6, 8) and the modulation shift (k*Imod) of the modulation current for the transmitting diodes (1) differ by a constant factor.

4. Communications module according to one of the preceding claims, **characterized in that** the control device (5) for regulating the biasing current of the transmitting diode (1) and the at least one monitor transmitting diode (6, 8) comprises a further control circuit, the signal which is received by the receiver device (7, 9) being evaluated by means of the further control circuit and at least one second control signal to the driver device (2) for setting the biasing current of the transmitting diode (1) and of the monitor transmitting diode (6, 8) being generated.

5. Communications module according to one of the preceding claims, **characterized in that** the monitor transmitting diode (6, 8) is supplied with a pilot tone frequency which is lower than that of the transmitting diode (1).

6. Communications module according to one of the preceding claims, **characterized in that**
- the monitor device comprises a further monitor transmitting diode (8) and a further receiver device (9),
- a further modulated optical signal which is generated by means of the further monitor transmitting diode (8) is converted into a further monitor signal by means of the further receiver device (9), and
- the receiver device (7) and the further receiver device (9) is connected to a safety device which switches off the transmitting diodes (1) if the received monitor signal and/or the further received monitor signal exceed a threshold value signal.

7. Communications module according to Claim 6, **characterized in that**
- the safety device comprises a comparator device (12) and a further comparator device (13),
- the received monitor signal is applied to an input (10) of the comparator device (12), and the further received monitor signal is applied to an input (11) of the further comparator device (13),
- the threshold value signal is applied to another input (14) of the comparator device (12) and to another input (15) of the further comparator device (13), and
- an output of the comparator device (12) and an output of the further comparator device (13) are connected to an input or to a further input of an OR device (16).

## Revendications

1. Module de communication comprenant
- plusieurs diodes (1) émettrices parallèles et
- au moins une diode (6, 8) émettrice de moniteur qui est placée près des diodes émettrices et qui a des propriétés optoélectroniques identiques ou dans une grande mesure semblables aux diodes émettrices,
- au moins un dispositif (2) d'attaque pour produire un courant de polarisation et un courant de modulation pour les diodes (1) émettrices et la diode (6, 8) émettrice de moniteur, et comprenant
- au moins un dispositif de moniteur qui comprend la diode (6, 8) émettrice de moniteur, un dispositif (7) de réception et un dispositif (5) de commande,
- dans lequel un signal optique modulé produit par la diode (6, 8) émettrice de moniteur est détecté par le dispositif (7) de réception, est transformé et est transmis en tant que signal de moniteur au dispositif (5) de commande qui, en fonction du signal transmis, produit un premier signal de commande sur le dispositif (2) d'attaque pour régler le courant de modulation pour les diodes (10) émettrices et la diode (6, 8) de moniteur,
**caractérisé**
**en ce que** l'amplitude (Imod) de modulation du courant de modulation pour la diode (6, 8) de moniteur est plus petite que l'amplitude (k ∗ Imod) de modulation du courant de modulation pour les diodes (1) émettrices.

2. Module de communication suivant la revendication 1, **caractérisé en ce que** l'amplitude de modulation du courant de modulation pour la diode (6, 8) émettrice de moniteur est si petite que la diode (6, 8) émettrice de moniteur peut toujours fonctionner dans le domaine linéaire d'une courbe caractéristique (B) de fonctionnement de la diode (6, 8) émettrice de moniteur.

3. Module de communication suivant la revendication 1 ou 2, **caractérisé en ce que** l'amplitude (lmod) de modulation du courant de modulation pour la diode (6, 8) émettrice de moniteur et l'amplitude (k ∗ Imod) de modulation du courant de modulation pour les diodes (1) émettrices se distinguent d'un facteur constant.

4. Module de communication suivant l'une des revendications précédentes, **caractérisé en ce que** le dispositif (5) de commande pour la régulation du courant de polarisation des diodes (1) émettrices et de la au moins une diode (6, 8) émettrice de moniteur comprend un autre circuit de régulation, le signal reçu par le dispositif (7, 9) de réception étant exploité au moyen de l'autre circuit de régulation et au moins un deuxième signal de commande sur le dispositif (2) d'attaque étant produit pour régler le courant de polarisation des diodes (1) émettrices et de la diode (6, 8) émettrice de moniteur.

5. Module de communication suivant l'une des revendications précédentes, **caractérisé en ce que** la diode (6, 8) émettrice de moniteur est alimentée à une fréquence de signal pilote plus basse que celle des diodes (1) émettrices.

6. Module de communication suivant l'une des revendications précédentes, **caractérisé en ce que**
- le dispositif de moniteur comprend une autre diode (8) émettrice de moniteur et un autre dispositif (9) de réception,
- un autre signal optique modulé et produit au moyen de l'autre diode (8) émettrice de moniteur est transformé à l'aide de l'autre dispositif (9) de réception en un autre signal de moniteur, et
- le dispositif (7) de réception et l'autre dispositif (9) de réception sont reliés à un dispositif de sécurité qui met les diodes (1) émettrices hors circuit lorsque le signal de moniteur reçu et/ou l'autre signal de moniteur reçu dépasse(nt) un signal de valeur de seuil.

7. Module de communication suivant la revendication 6, **caractérisé en ce que**
- le dispositif de sécurité comprend un dispositif (12) de comparaison et un autre dispositif (13) de comparaison,
- le signal de moniteur reçu s'applique à une entrée (10) du dispositif (12) de comparaison et l'autre signal de moniteur reçu à une entrée (11) de l'autre dispositif (13) de comparaison,
- le signal de valeur de seuil s'applique à une autre entrée (14) du dispositif (12) de comparaison et à une entrée (15) de l'autre dispositif (13) de comparaison, et
- une sortie du dispositif (12) de comparaison et une sortie de l'autre dispositif (13) de comparaison sont reliées à une entrée ou à une autre entrée d'un dispositif (16) OU.
